# EUROPEAN PATENT APPLICATION

(11) **EP 1 136 832 A2**
(43) Date of publication of application: **26.09.2001**
(21) Application number: 01107187.5
(22) Date of filing: 22.03.2001
(51) Int. Cl.: G01R 31/30

(54) **Monitored burn-in test system and monitored burn-in test method of microcomputers**

(30) Priority: 22.03.2000 JP 2000084759
(71) Applicant: NEC CORPORATION, Tokyo (JP)
(72) Inventor: Ajiro, Kazuyoshi, Tokyo (JP)
(74) Representative: Betten & Resch

(57) **Abstract**

A monitored burn-in test system and a monitored burn-in test method of microcomputers, which are capable of implementing the monitored burn-in test without increasing a load of software and improving the function of a tester unit. When microcomputers supply a tester unit with measurement data stored in a data compressing circuit comprised of a linear feedback resister, test data outputted by all of the microcomputers can be read synchronously into the tester unit by shifting out the measurement data synchronously with a monitoring clock signal outputted by the tester unit. Thus, it is made possible to monitor the test results of all microcomputers at the same time in the tester unit. Therefore, it can be avoided that a load of software gets heavier since the monitoring of the test results is certainly executed by the tester unit.

## Description

### BACKGROUND OF THE INVENTION

The present invention relates to a monitored burn-in test system which implements a self-test by a monitored burn-in test, and a monitored burn-in test method of microcomputers.

### Description of the Prior Art

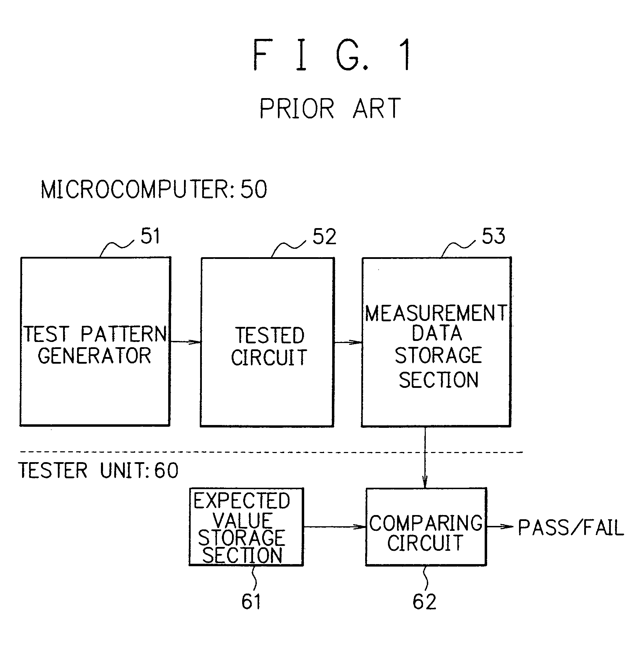

In applying BIST method to a monitored burn-in test, the system shown in Fig. 1 is known. In Fig. 1, the monitored burn-in test is implemented employing a microcomputer 50 and a tester unit 60 which obtains measurement data of the test.

Here, the microcomputer 50 includes a test pattern generator 51 which outputs a test pattern of the monitored burn-in test, a tested circuit 52 located on the microcomputer 50 which is subject to the monitored burn-in test according to the test pattern, and a measurement data storage section 53, in which the tested circuit 52 operates based on the test pattern, and the measurement data storage section 53 stores outputs thereof as measurement data.

Besides, the tester unit 60 includes an expected value storage section 61 and a comparing circuit 62, in which the expected value storage section 61 stores a prescribed expected value, which is determined in advance, of the measurement data, and the comparing circuit 62 compares actual measurement data with the expected value stored in the expected value storage section 61 and judges the measurement data whether pass or fail.

In the test method called BIST method, the test pattern generator 51 and the measurement data storage section 53 are incorporated in the microcomputer 50. A test pattern generated by the test pattern generator 51 is inputted to the tested circuit 52. The tested circuit 52 starts the operation and an operation result thereof is stored in the measurement data storage section 53 as the measurement data, consequently the stored measurement data is outputted to the tester unit 60.

In the tester unit 60 which has received the above measurement data, the comparing circuit 62 reads the expected value stored in the expected value storage section 61 and judges the microcomputer 50 whether pass or fail by comparing the measurement data with the expected value.

In the test method, however, there has been a problem that hardware in the microcomputer 50 is necessitated to be larger since the test pattern generator 51 and the measurement data storage section 53 have to be incorporated in the microcomputer 50.

Moreover, when the circuits are incorporated in the microcomputer 50 as described above, wiring is needed to connect each circuit, and owing to the wiring, a time lag in signals generated at each circuit is necessitated to be prolonged.

Further, since the test pattern generator 51 generates the test pattern at random by hardware circuits, there has been a problem that the failure detection rate of the microcomputer 50 is necessitated to be indefinite.

In order to solve these problems, the present applicant has proposed "Microcomputer and Burn-in test Method of Microcomputer" disclosed in Japanese Patent Application Laid-Open No. HEI11-242610.

An invention described in the above-mentioned Patent Application is provided with a microcomputer capable of implementing a burn-in test, comprising a memory for storing programs, a CPU (Central Processing Unit) for practicing the programs stored in the memory and a plurality of peripheral functional units on the same semiconductor chip, wherein the microcomputer includes a test pattern generating means for generating test patterns of the burn-in test, a measurement data storage means for storing measurement data of the burn-in test implemented according to the test pattern generated by the test pattern generating means, and an external signal input / output means for inputting a control signal of the microcomputer as well as outputting the measurement data, and the measurement data storage means includes a data compressing means for compressing the measurement data to store it.

In the microcomputer having the constitution as described above, hardware circuit, which realizes each function such as generating the test pattern using the program in the memory and compressing the measurement data of the burn-in test, is necessary. Thus, the microcomputer does not require having the hardware circuits incorporated in it, and thereby the burn-in test can be implemented with simple structure.

Moreover, since the test pattern is generated according to the test program stored in the memory, the failure detection rate of the microcomputer, which is subject to the burn-in test, can be calculated precisely.

However, in the above described "Microcomputer and Burn-in Test Method of Microcomputer" disclosed in the above-mentioned Patent Application, there has been problems as follows. First, in a plurality of microcomputers loaded on a burn-in board, it is difficult to synchronize output signals and compare the output signals at the same time. Besides, the conventional tester unit can only perform monitoring with a very low frequency compared to an operating frequency of the microcomputers. Further, when the operating frequency of the microcomputers become high, it is difficult to synchronize the output signals of all the microcomputers which perform the monitoring.

### SUMMARY OF THE INVENTION

It is therefore an object of the present invention to provide a monitored burn-in test system and a monitored burn-in test method of microcomputers, which are capable of implementing the monitored burn-in test without increasing a load on the software and improving the function of a tester unit.

In accordance with the first aspect of the present invention, there is provided a monitored burn-in test system comprising microcomputers capable of implementing a monitored burn-in test according to a test pattern generating program, each of which including a memory for storing a test pattern generating program which generates a test pattern of the monitored burn-in test and also measurement data of the monitored burn-in test which has been implemented according to the test pattern generating program and a CPU for practicing the program stored in the memory, and a tester unit which judges the measurement data whether pass or fail, wherein the microcomputers shift the measurement data out of the memory synchronously with a monitoring clock outputted from the tester unit.

In accordance with the second aspect of the present invention, in the monitored burn-in test system, in the first aspect, the measurement data is compressed by a data compressing means to be stored.

In accordance with the third aspect of the present invention, in the monitored burn-in test system, in the second aspect, the data compressing means comprises hardware circuit constituted of a linear feedback shift resister.

In accordance with the fourth aspect of the present invention, in the monitored burn-in test system, in the one of aspect first to third, the microcomputers supply the tester unit with a monitoring enabling signal which indicates the permission to read the measurement data at a stage where preparations for outputting the measurement data to the tester unit have been made.

In accordance with the fifth aspect of the present invention, in the monitored burn-in test system, in the forth aspect, the microcomputers enter a deactivated state at a stage where the monitoring enabling signal has been outputted to the tester unit.

In accordance with the sixth aspect of the present invention, in the monitored burn-in test system, in the fifth aspect, the tester unit supplies the microcomputers with a monitoring completed signal which indicates the completion of reading the measurement data at a stage where reading of the measurement data from the microcomputers has been completed, and the microcomputers are released from the deactivated state with receiving the monitoring completed signal as an interrupt input.

In accordance with the seventh aspect of the present invention, there is provided a monitored burn-in test method of microcomputers comprising the steps of storing a test pattern generating program in a memory of each microcomputer, implementing a monitored burn-in test by activating the test pattern generating program with an external input signal of the microcomputers, compressing measurement data, namely a result of the monitored burn-in test, using a data compressing means, and shifting out the measurement data synchronously with a monitoring clock from a tester unit which is connected to the microcomputers and judges the measurement data whether pass or fail.

### BRIEF DESCRIPTION OF THE DRAWINGS

The objects and features of the present invention will become more apparent from the consideration of the following detailed description taken in conjunction with the accompanying drawings, in which:
Fig. 1 is a block diagram showing constitution of a conventional burn-in test system testing a microcomputer;
Fig. 2 is a block diagram showing constitution of a monitored burn-in test system implementing the burn-in test according to an embodiment of the present invention;
Fig. 3 is a block diagram showing a microcomputer loaded on a burn-in board;
Fig. 4 is a block diagram showing a data compressing circuit of the microcomputer;
Fig. 5A is a view showing operation of the burn-in test implemented in a RAM, a resister or a serial communication;
Fig. 5B is a view showing operation of the burn-in test implemented in a CPU; and
Fig. 5C is a view showing operation of the burn-in test implemented in a peripheral circuit such as a timer.

### DESCRIPTION OF THE PREFERRED EMBODIMENTS

Referring now to the drawings, a description of preferred embodiment of a monitored burn-in test system and a monitored burn-in test method of microcomputers according to the present invention will be given in detail.

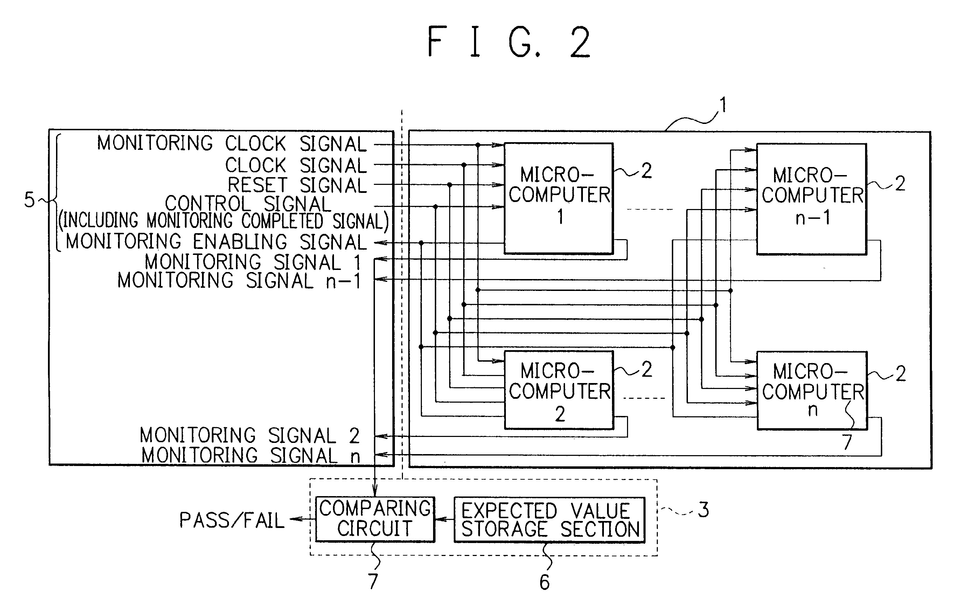

Figs. 2 to 5 illustrate the embodiments of the monitored burn-in test system and the monitored burn-in test method of microcomputers according to the present invention.

Fig. 2 shows constitution of the monitored burn-in test system which executes the monitored burn-in test for microcomputers 2 according to an embodiment of the present invention. In Fig. 2, the monitored burn-in test system is provided with a plurality of microcomputers (2-1~2-n: "n" is a number of microcomputers), and the monitored burn-in, test is executed using a burn-in board 1 which is inserted in a burn-in test furnace and a tester unit 3 which measures test data.

Here, the burn-in board is provided with a plurality of microcomputers 2-1~2-n executing the monitored burn-in test and an external interface 4 which outputs measurement data of the burn-in test to the outside as well as receives a control signal 5 supplied from the outside.

Besides, the tester unit 3 includes an expected value storage section 6 for storing the prescribed expected value of the measurement data, namely a test result. Further, the tester unit 3 includes a comparing circuit 7 for receiving the measurement data and comparing the measurement data with the expected value stored in the expected value storage section 6 to judge the measurement data whether pass or fail.

In the above described constitution, the burn-in test starts in the microcomputers 2-1~2-n when the prescribed control signal is inputted to the external interface 4. The measurement data of the burn-in test is supplied to the tester unit 3 from the external interface 4. In the tester unit 3 having received the measurement data, the comparing circuit 7 reads the expected value stored in the expected value storage section 6 and compares it with the measurement data to judge the microcomputer whether pass or fail.

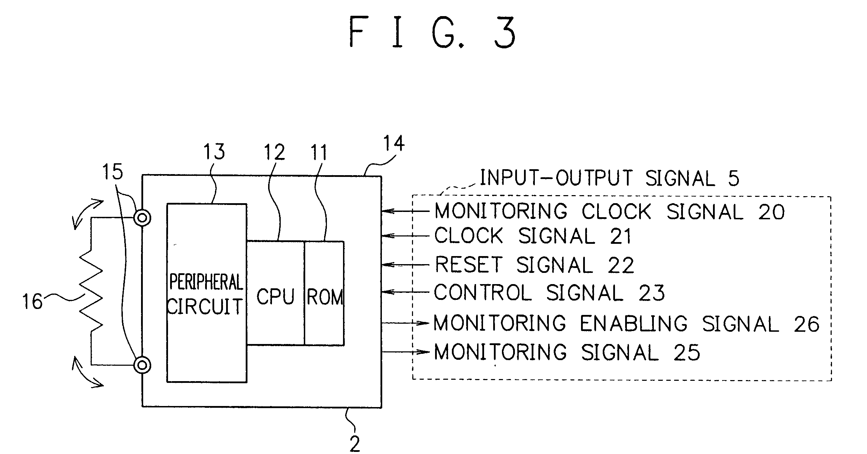

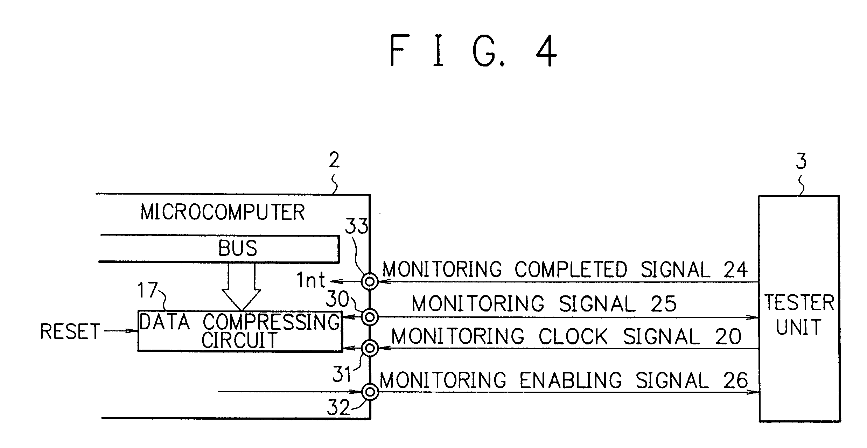

Next, the constitution of the microcomputer 2 loaded on the burn-in board 1 will be described referring to Figs. 3 and 4. In Fig. 3, the microcomputer 2 comprises a ROM 11 where a test pattern generating program is stored, a CPU 12 for practicing the test pattern generating program stored in the ROM 11, a peripheral circuit 13 which is located on the microcomputer 2 for realizing prescribed functions, an input / output interface 14 which is connected to the external interface 4 of the burn-in board 1 for outputting the measurement data, namely a result of the monitored burn-in test, as well as receiving the control signal, input / output ports 15 of the microcomputer 2, and a resister 16 which is inserted between the input / output ports 15 when they are connected to each other.

Moreover, as shown in Fig. 4, the microcomputer 2 also includes a data compressing circuit 17 on the hardware for compressing a monitoring signal which is a result of the test. In the present embodiment, the signal output is serial, thus the data compressing circuit 17 is employed to reduce the number of output data by compressing it. Incidentally, the data compressing circuit 17 comprises a linear feedback shift resister which is generally used in the field of data compression. The linear feedback shift resister is realized by adding a simply structured hardware circuit.

The signals which are supplied to the microcomputer 2 through the input / output interface 14 include a monitoring clock signal 20, a clock signal 21, a reset signal 22, a control signal 23 and a monitoring completed signal 24.

The clock signal 21 is a base clock to bring the microcomputer 2 into operation.

The reset signal 22 is a signal for resetting the microcomputer 2.

The control signal 23 is a signal for controlling the operation such as switching an inner operation of the microcomputer 2 and switching a program block.

The monitoring clock 20 is a signal for shifting the monitoring signal which indicates the result of the monitored burn-in test out of the data compressing circuit 17.

The monitoring completed signal 24 is a signal for informing that the monitoring has been completed in the tester unit 3 and releasing the CPU 12 of the microcomputer 2 from the deactivated state.

Besides, the signals that are outputted from the microcomputer 2 through the input / output interface 14 are a monitoring signal 25 and a monitoring enabling signal 26.

The monitoring signal 25 is measurement data of the burn-in test executed in the microcomputer 2.

The monitoring enabling signal 26 is indicating that the microcomputer 2 has completed a section of the test and entered into a data outputting state. Incidentally, the terminal which is provided to the burn-in board 1 for inputting the monitoring enabling signal 26 cannot be used for the other purposes since it is occupied by the monitoring enabling signal 26 during the monitored burn-in test. Therefore, it is preferable to have the terminal as a dedicated terminal.

As shown in Fig. 3, a data output terminal 30 for outputting the monitoring signal 25 and a monitoring clock input terminal 31 for inputting the monitoring clock signal 20 are connected to the data compressing circuit 17. Since it is not possible to provide each microcomputer 2 loaded on the burn-in board 1 with a plurality of output terminals, the data output terminal 30 is a shift-out terminal for serial data. Moreover, the microcomputer 2 also needs a monitoring enabling signal output terminal 32 and a monitoring completed signal input terminal 33.

The present embodiment having above composition is constituted in order to solve the following problems.

As the first problem, it is difficult to synchronize the monitoring signals 25 outputted by each microcomputer 2-i ("i" is any one of 1 to n) when an operating frequency of the microcomputers 2-1~2-n become high. Therefore, it is impossible to synchronize the monitoring signals 25 outputted from the microcomputers 2 loaded on the burn-in board 1 and compare the data value of all monitoring signals 25 with the expected value at the same time.

As the second problem, the prior test systems can only perform the monitoring with a very low frequency in response to the operating frequency of the microcomputers 2. Therefore, the microcomputers 2 have to lower the data output frequency at the time of outputting the monitoring signals to compare the data with the expected value in the tester unit 3.

In order to solve these problems, the present embodiment employs the constitution described below.

The microcomputers 2 implement a test pattern stored in the ROM 11. On the occasion, each microcomputer 2 may not need to synchronize. Since the microcomputers 2 operate without synchronizing with each other, it is necessary to inform the tester unit 3 whether the test has been completed and preparations for outputting the data have been made or not. Thus, the microcomputers 2 supply the tester unit 3 with the monitoring enabling signals 26 which indicate the completion of the test and that preparations for outputting the data have been made at a stage where the test has been completed. The tester unit 3 fetches the data indicating results of the test from the microcomputers 2 at a stage of having received the monitoring enabling signals 26 from all microcomputers 2. Thereby, it is made possible to synchronize all monitoring enabling signals 25 outputted from the microcomputers 2 and monitor the test results of all microcomputers 2.

Incidentally, the microcomputers 2 enter a deactivated state at a stage where the microcomputers 2 have been prepared to output the data and outputted the monitoring enabling signals 26, so as not to proceed to the next testing operation.

Moreover, in order to solve the problem in difference between the operating frequency of the microcomputers 2 and the monitoring frequency of the tester unit 3, the tester unit 3 goes to have the data rather than the microcomputers 2 output the data.

The monitoring clock signal 20 for outputting the data is supplied to the microcomputers 2 and the data compressing circuit 17 of the microcomputers 2 outputs the monitoring signal 25 synchronously with the clock.

Therefore, the microcomputers 2 have to neither lower the operating frequency to the level of the monitoring frequency of the tester unit 3 for outputting the monitoring signal 25 nor synchronize other microcomputers for outputting the data.

The microcomputers 2 have to proceed to the next test at a stage where the tester unit 3 has completed taking the data. However, the microcomputers 2 are incapable of recognizing the completion of taking the data by the tester unit 3. Thus the tester unit 3 supplies microcomputers 2 with the monitoring completed signal 24 for releasing the microcomputers 2 from the deactivated state. The microcomputers 2 input the monitoring completed signal 24 as an interrupt input through a monitoring completed signal input terminal 33 as shown in Fig. 4, and thereby release the deactivated state.

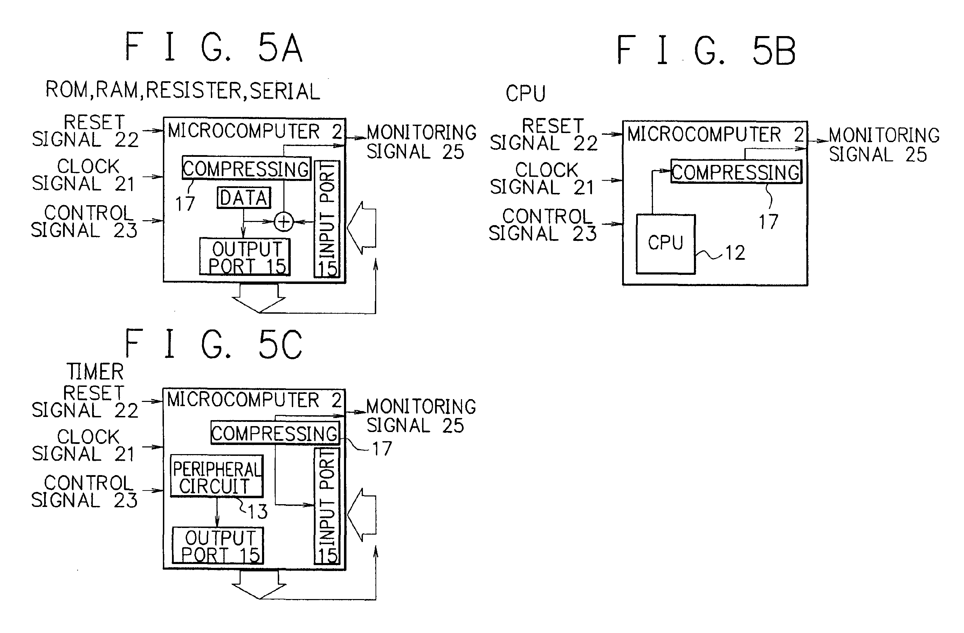

Next, the burn-in test implemented according to the present embodiment will be described referring to Fig. 5 A, 5 B and 5 C.

The microcomputers 2 installed on the burn-in board 1 are sorted into each feature and its input/output ports are connected by the resister 16 in one set according to the features.

Fig. 5 A is a view showing an operation of the burn-in test implemented with respect to a RAM, a resister or a serial communication. When the burn-in test is implemented in the RAM or the resister, data is written on the RAM or the resister. The data is outputted through the output port 15 as well as read through the input port 15, and supplied to the data compressing circuit 17 to be compressed.

As for the serial communication, the input and output ports are connected by the resister 16, and an output value of the input port 15 and an input value of the output port 15 are compared to see whether they coincide each other. The result data is supplied to the data compressing circuit 17 and compressed. However, at the time of outputting the monitoring signal, there is no need for an identity comparison on the inside since the identity comparison with the expected value is made on the side of tester unit 3.

Fig. 5 B is a view showing an operation of the burn-in test implemented in the CPU 12. In Fig. 5 B, the CPU 12 executes processes such as an internal operation and outputs the result data one by one to the data compressing circuit 17 for compressing them.

Fig. 5 C is a peripheral circuit 13 showing an operation of the burn-in test implemented particularly in a circuit which outputs data, such as the timer. In Fig. 5 C, the output value of the timer circuit is outputted through the output port 15 and read through the input port 15 which is connected to the output port 15 by the resister 16, then supplied to the data compressing circuit 17 one by one to be compressed.

Each microcomputer 2 supplies the tester unit 3 with the monitoring enabling signal 26 and enters a deactivated state at a stage where the burn-in test has been completed and preparations for outputting the data have been made.

The tester unit 3 supplies microcomputers 2 with the monitoring clock signal 20 when the microcomputers 2 output the monitoring enabling signals 26. The data compressing circuit 17 of the microcomputers 2 shifts out the data by one bit synchronously with the monitoring clock signal 20. The tester unit 3 also compares the data outputted from each microcomputer 2 with the expected value stored in the expected value storage section 6 to detect defective chips. Moreover, it is made possible to monitor the test results of all microcomputers 2 at the same time in the tester unit 3, since the data compressed by the data compressing circuit 17 is outputted synchronously with the monitoring clock 20.

Further, the tester unit 3 outputs the monitoring completed signal 24 to release the microcomputers 2 from the deactivated state at the stage where absorption of the data has been completed. The microcomputers 2 receive the monitoring completed signal 24 as an interrupt signal through the monitoring completed signal input terminal 33 and release the deactivated state to proceed to the next test.

In the embodiment described above, the data of the results of the monitored burn-in test is hold after compressed by the data compressing circuit 17 and the monitoring enabling signal which indicates the completion of the test is supplied to the tester unit 3. When the test operations of all microcomputers 2 have been completed, the monitoring clock signal is outputted to the microcomputers 2 from the tester unit 3 and the data compressing circuit 17 which is constituted of a linear feedback shift resister outputs the data synchronously with the monitoring clock. Thus, it is made possible to synchronize all monitoring signals outputted from microcomputers 2 and monitor the test results of all microcomputers 2. Thereby, it can be avoided that a load of software gets heavier since the monitoring of the test results is certainly executed by the tester unit 3.

Moreover, it also can be avoided that hardware gets larger by means of holding the test pattern generating program which generates the test pattern in the ROM and employing a linear feedback resister constituted of hardware circuit having simple structure for the data compressing circuit which compresses the data, namely the results of the burn-in test. Besides, calculations of failure detection rate can be executed precisely by means of executing the test pattern by software specifications.

Further, the monitoring clock signal 20 for outputting the data is supplied to the microcomputer 2 and the data compressing circuit 17 of the microcomputer 2 outputs the monitoring signal 25 synchronously with the clock. Thus, the microcomputer 2 has to neither lower the operating frequency to the level of the monitoring frequency of the tester unit 3 for outputting the monitoring signal 25 nor synchronize with other microcomputers for outputting the data.

As it has been discussed above, with respect to the monitored burn-in test system and the monitored burn-in test method of the microcomputer according to the present invention, when microcomputers supply a tester unit with measurement data stored in a memory, test data outputted by all of the microcomputers can be read synchronously into the tester unit by shifting the measurement data out of the memory synchronously with a monitoring clock signal outputted by the tester unit. Thus, it is made possible to monitor the test results of all microcomputers at the same time in the tester unit. Therefore, it can be avoided that a load of software gets heavier since the monitoring of the test results is certainly executed by the tester unit 3.

Moreover, the microcomputers can reduce the number of the data outputted therefrom by means of memorizing the measurement data which is compressed by a data compressing means constituted of a linear feedback resister.

Further, it also can be avoided that hardware gets larger by means of holding a test pattern generating program which generates a test pattern in the memory and employing a linear feedback resister constituted of hardware circuit having simple structure for the data compressing means which compresses the data, namely the results of the burn-in test. Besides, calculations of failure detection rate can be executed precisely since the test pattern is realized by software specifications.

Furthermore, the tester unit can detect the completion of the testing operation of all microcomputers since the microcomputers supply the tester unit with monitoring enabling signals indicating permission to read the measurement data at a stage where the burn-in test has been completed and preparations for outputting the measurement data to the tester unit have been made. Thus, the measurement data can be read from the microcomputers at a stage where the tests have been completed.

Furthermore, it can be avoided that the microcomputers proceed to the next testing operation since the microcomputers enter a deactivated state at a stage of having supplied the tester unit with the monitoring enabling signals.

Furthermore, the tester unit supplies the microcomputers with the monitoring completed signal indicating the completion of reading the measurement data at a stage of having completed reading the measurement data from the microcomputers, and the microcomputers receive the monitoring completed signal as an interrupt input. Thereby the microcomputers are released from the deactivated state and proceed to the next testing operation.

While preferred embodiments of the invention have been described, it is not to be restricted by those embodiments but only by the appended claims. It is to be appreciated that those skilled in the art can change or modify the embodiments without departing from the scope and spirit of the present invention.

## Claims

1. A monitored burn-in test device comprising a plurality of microcomputers and a tester unit, **characterized in that**:
each of the microcomputers includes a memory for storing a test pattern generating program which generates a test pattern of the monitored burn-in test and also measurement data of the monitored burn-in test which has been implemented according to the test pattern generating program, and a CPU for practicing the program stored in the memory;
the microcomputer implements a monitored burn-in test according to a test pattern generating program, and shift the measurement data out of the memory synchronously with a monitoring clock outputted from the tester unit; and
the tester unit which judges the measurement data whether pass or fail.

2. The monitored burn-in test system as claimed in claim 1, wherein the microcomputer further includes a data compressing means for compressing the measurement data to store.

3. A monitored burn-in test system as claimed in claim 2, wherein the data compressing means comprises hardware circuit constituted of a linear feedback shift resister.

4. A monitored burn-in test system as claimed in claim 1, wherein the microcomputers supply the tester unit with monitoring enabling signals which indicate the permission to read the measurement data at a stage where preparations for outputting the measurement data to the tester unit have been made.

5. A monitored burn-in test system as claimed in claim 2, wherein the microcomputers supply the tester unit with monitoring enabling signals which indicate the permission to read the measurement data at a stage where preparations for outputting the measurement data to the tester unit have been made.

6. A monitored burn-in test system as claimed in claim 3, wherein the microcomputers supply the tester unit with monitoring enabling signals which indicate the permission to read the measurement data at a stage where preparations for outputting the measurement data to the tester unit have been made.

7. A monitored burn-in test system as claimed in claim 4, wherein the microcomputers enter a deactivated state at a stage where the monitoring enabling signal has been outputted to the tester unit.

8. A monitored burn-in test system as claimed in claim 5, wherein the tester unit supplies the microcomputers with a monitoring completed signal which indicates the completion of reading the measurement data after reading of the measurement data from the microcomputers has been completed, and the microcomputers are released from the deactivated state with receiving the monitoring completed signal as an interrupt input.

9. A monitored burn-in test method of microcomputers comprising the steps of:
storing a test pattern generating program in a memory of each microcomputer;
implementing a monitored burn-in test by activating the test pattern generating program with a signal inputted from the outside of the microcomputers;
compressing a measurement data, namely a result of the monitored burn-in test, using a data compressing means; and
shifting out the measurement data synchronously with a monitoring clock from a tester unit which is connected to the microcomputers and judges the measurement data whether pass or fail.
